# FASCICULE DE BREVET EUROPEEN

(11) **EP 0 762 576 B1**
(45) Date de publication et mention de la délivrance du brevet: **03.01.2001**
(21) Numéro de dépôt: 96401716.4
(22) Date de dépôt: 01.08.1996
(51) Int. Cl.: H01S 5/06, H01S 5/10

(54) **Composant opto-électronique intégré**
Integriertes optoelektronisches Bauelement
Integrated opto-electronic device

(30) Priorité: 04.08.1995 FR 9509541
(43) Date de publication de la demande: 12.03.1997
(73) Titulaire: ALCATEL, 75008 Paris (FR)
(72) Inventeur: Gurib, Salim, 91290 Arpajon (FR); Jaquet, Joel, 92160 Antony (FR); Labourie, Christine, 94800 Villejuif (FR); Gaumont-Goarin, Elisabeth, 78460 Chevreuse (FR)
(74) Mandataire: Fournier, Michel Robert Marie

(56) Documents cités:
- EP-A- 0 409 177
- IEEE PHOTONICS TECHNOLOGY LETTERS, vol. 6, no. 2, 1 Février 1994, pages 170-172, XP000439743 DOUSSIERE P ET AL: "1.55 M POLARISATION INDEPENDENT SEMICONDUCTOR OPTICAL AMPLIFIER WITH 25 DB FIBER TO FIBER GAIN"
- PROCEEDINGS OF THE CONFERENCE ON LASERS AND ELECTRO OPTICS (CLEO), ANAHEIM, MAY 10 - 15, 1992, vol. 12, 1 Janvier 1992, INSTITUTE OF ELECTRICAL AND ELECTRONICS ENGINEERS, page 552/553 XP002001777 DURHUUS T ET AL: "HIGH-SPEED ALL-OPTICAL GATING USING A TWO-SECTION SEMICONDUCTOR OPTICAL AMPLIFIER STRUCTURE"
- ELECTRONICS LETTERS, vol. 30, no. 2, 20 Janvier 1994, page 133/134 XP000426287 YASAKA H ET AL: "BROAD-RANGE WAVELENGTH CONVERSION OF 10 GBIT/S SIGNAL USING A SUPERSTRUCTURE GRATING DISTRIBUTED BRAGG REFLECTOR LASER"
- PROCEEDINGS OF THE EUROPEAN CONFERENCE ON OPTICAL COMMUNICATION (EC, MONTREUX, SEPT. 12 - 16, 1993 INVITED PAPERS, vol. 1, 12 Septembre 1993, SWISS ELECTROTECHNICAL ASSOCIATION, pages 60-67, XP000492152 STUBKJAER K ET AL: "SEMICONDUCTOR OPTIAL AMPLIFIERS AS LINEAR AMPLIFIERS, GATES AND WAVELENGTH CONVERTERS"
- OFC'94, San Jose, California, 20-25 février 1994, Proceedings Volume 4 1994 Technical Digest Series, Optical Society of America, Washington, XP002001778
- PROCEEDINGS OF THE EUROPEAN CONFERENCE ON OPTICAL COMMUNICATION (EC, FIRENZE, SEPT. 25 - 29, 1994, vol. 2, 1 Janvier 1994, ISTITUTO INTERNAZIONALE DELLE COMUNICAZIONI, pages 651-654, XP002001779 GURIB S ET AL: "ANTIREFLECTION COATED DISTRIBUTED BRAGG REFLECTOR LASER FOR ALL OPTICAL WAVELENGTH CONVERSION WITH WAVELENGTH INSENSITIVITY AND EXTINCTION RATIO ENHANCEMENT CAPABILITY"
- EUROPEAN TRANSACTIONS ON TELECOMMUNICATIONS AND RELATED TECHNOLOGIES, vol. 5, no. 4, Juillet 1994 - Août 1994, MILANO, pages 103-113, XP002001776 P. SPANO ET AL.: "Frequency Conversion in Semiconductor Lasers and Amplifiers"
- PROCEEDINGS OF THE EUROPEAN CONFERENCE ON OPTICAL COMMUNICATION (EC REGULAR PAPERS, BERLIN, SEPT. 27 - OCT. 1, 1992, vol. 1, 1 Janvier 1992, INFORMATIONSTECHNISCHE GESELLSCHAFT IM VDE, pages 441-444, XP002001780 MIKKELSEN B ET AL: "PENALTY FREE WAVELENGTH CONVERSION OF 2.5 GBIT/S SIGNALS USING A TUNEABLE DBR-LASER"
- PROCEEDINGS OF THE EUROPEAN CONFERENCE ON OPTICAL COMMUNICATION (EC, MONTREUX, SEPT. 12 - 16, 1993 REGULAR PAPERS, vol. 2, 12 Septembre 1993, SWISS ELECTROTECHNICAL ASSOCIATION, pages 237-240, XP000492210 BRAAGAARD C ET AL: "OPTIMIZATION OF DBR WAVELENGTH CONVERTERS"
- JOURNAL OF LIGHTWAVE TECHNOLOGY, vol. 12, no. 6, 1 Juin 1994, pages 943-951, XP000484209 BRAAGAARD C ET AL: "MODELING THE DBR LASER USED AS WAVELENGTH CONVERSION DEVICE"
- OFC'94, San Jose, California, 20-25 février 1994, Proceedings Volume 4 1994 Technical Digest Series, Optical Society of America, Washington, XP002001778, R. Pedersen et al.: 'Simple wavelenght converter for bit-rate-independent operation at data rates as high as 10 Gbit/s' page 249-250

## Description

L'invention se situe dans le domaine des dispositifs photoniques ou opto-électroniques intégrés utilisables notamment pour la transmission ou la commutation de données numériques optiques. L'invention concerne plus particulièrement les composants munis d'un milieu amplificateur saturable, c'est-à-dire présentant un phénomène de déplétion des porteurs, en vue de les utiliser en tant que convertisseurs de longueur d'onde ou d'amplificateurs à gain stabilisé.

Dans les systèmes de transmission optique, les informations sont généralement sous la forme de données binaires représentées par des impulsions modulant une onde porteuse optique. Pour réaliser des opérations de multiplexage ou de démultiplexage de longueur d'onde, par exemple dans des matrices de commutation spatio-temporelles, il est souvent nécessaire de pouvoir effectuer des conversions de longueur d'onde. Une conversion de longueur d'onde consiste à remplacer la longueur d'onde portant une information reçue par une autre longueur d'onde, généralement différente, pour former une onde de sortie de même modulation que l'onde d'entrée. Avantageusement, cette conversion s'accompagne d'une amplification et d'une remise en forme du signal.

Pour permettre des transmissions à débit élevé, il est souhaitable que ces conversions de longueur d'onde soient réalisées par des moyens exclusivement optiques, c'est-à-dire en l'absence de toute conversion optique-électronique et réciproquement.

Une première contrainte imposée aux convertisseurs de longueur d'onde est qu'ils doivent fournir une onde de sortie monomode indépendante des caractéristiques de l'onde d'entrée. Ils doivent donc être indépendants de la longueur d'onde portant les signaux d'entrée. Il est également souhaitable qu'ils soient accordables électriquement en longueur d'onde et indépendants de l'état de polarisation des ondes reçues. En effet, en transmission optique, les signaux sont généralement véhiculés par des fibres optiques qui introduisent toujours une indétermination de l'état de polarisation des ondes apparaissant à leur sortie. Un convertisseur de longueur d'onde sensible à l'état de polarisation du signal d'entrée nécessiterait donc la présence d'un contrôleur de polarisation disposé entre l'extrémité de la fibre et l'entrée du convertisseur. Cette solution serait donc difficilement applicable pour une réalisation industrielle.

Pour éviter cet inconvénient, une première solution consisterait à exploiter le caractère saturable des amplificateurs optiques semiconducteurs. On introduit dans l'amplificateur en même temps que le signal d'entrée une onde auxiliaire monomode de puissance constante et ayant une longueur d'onde différente de celle de la porteuse du signal d'entrée. La modulation du signal d'entrée provoquant une modulation du gain de l'amplificateur, l'onde auxiliaire subira une modulation correspondante en opposition de phase. L'indépendance vis-à-vis de la polarisation du signal d'entrée pourra être obtenue en rendant l'amplificateur insensible à la polarisation, par exemple par un dimensionnement géométrique approprié de la couche active (section sensiblement carrée) ou en utilisant une structure à puits quantiques contraints. Toutefois, cette solution n'autorise qu'une remise en forme des signaux limitée. De plus, l'amplificateur doit être associé à une source laser, ce qui rend le système plus complexe et moins performant : pertes de couplage supplémentaires, coût plus élevé.

Selon une autre possibilité, on peut utiliser l'effet de déplétion des porteurs dans un laser de type DBR ("Distributed Bragg Reflector"). Ce composant est accordable en longueur d'onde mais il est par contre sensible à la polarisation à cause de la structure active utilisée : guide fortement rectangulaire ou puit quantique sensible à la polarisation.

En variante, on pourrait aussi penser à utiliser un oscillateur laser à contre-réaction distribuée DFB ("distributed feedback"), en prévoyant un milieu amplificateur à section sensiblement carrée de façon à le rendre insensible à la polarisation. Toutefois, ce composant n'est pas accordable électriquement en longueur d'onde, et du fait que le milieu amplificateur est insensible à la polarisation, l'état de polarisation de l'émission laser est indéterminé. On aurait donc une onde monomode transversalement qu'après adjonction d'un polariseur de sortie. Ce type de composant déjà utilisé en tant qu'amplificateur à gain stabilisé montre toutefois des performances accrues en termes de puissance de commande.

L'invention a pour but de remédier aux inconvénients des solutions mentionnées précédemment en proposant un composant opto-électronique intégré possédant la fonction de source laser accordable en longueur d'onde et utilisable en tant que convertisseur de longueur d'onde ou amplificateur à gain stabilisé insensible à l'état de polarisation de l'onde d'entrée.

Dans ce but, l'invention a pour objet un composant opto-électronique intégré comportant :
- un segment d'amplification muni d'un milieu amplificateur optique saturable et
- un segment d'accord muni d'un guide optique couplé à une première extrémité dudit milieu amplificateur,
lesdits segments amplificateur et d'accord étant délimités par un premier et un second réflecteur, ledit premier réflecteur étant réalisé au moyen d'un réseau de Bragg placé dans ledit segment d'accord, ledit composant étant caractérisé en ce que ledit milieu amplificateur est dimensionné de façon à présenter un gain sensiblement indépendant de la polarisation des ondes optiques qu'il reçoit et en ce que ledit guide optique du segment d'accord est dimensionné au niveau du réseau de Bragg de façon à imposer une oscillation optique monomode transversalement avec une polarisation rectiligne.

Pour rendre le milieu amplificateur indépendant de la polarisation des ondes reçues, on peut avoir recours à la technique des puits quantiques contraints. Toutefois, cette technique est délicate à mettre en oeuvre. Il est plus simple d'agir sur la géométrie du milieu amplificateur du segment d'amplification de façon à imposer un facteur de confinement indépendant des directions considérées dans chaque section du milieu. La solution idéale serait bien entendu que la couche active formant le milieu amplificateur ait une section circulaire. En pratique, pour des raisons de facilité de fabrication, on pourra de se contenter d'une section sensiblement carrée ; voir par exemple IEEE PHOTONICS TECHNOLOGY LETTERS, vol. 6, no. 2, 1 février 1994, pages 170-172, DOUSSIERE P ET AL, ou PROCEEDINGS OF THE EUROPEAN CONFERENCE ON OPTICAL COMMUNICATION (EC, MONTREUX, SEPT. 12 - 16, 1993 INVITED PAPERS, vol. 1, 12 septembre 1993, SWISS ELECTROTECHNICAL ASSOCIATION, pages 60-67, STUBKJAER K ET AL.

Aussi, selon un mode de réalisation préféré de l'invention, le composant est caractérisé en ce que ledit milieu amplificateur comprend une couche active ayant une section sensiblement carrée et en ce que ledit segment d'accord est constitué d'un segment réflecteur couplé au segment amplificateur par l'intermédiaire d'un segment de phase, ledit segment réflecteur comportant ledit réseau de Bragg et un guide optique rectangulaire associé, ledit segment de phase étant muni d'un guide optique de largeur variable de façon à assurer la transition entre la largeur de ladite couche active et la largeur du guide optique du segment réflecteur.

Ainsi, le guide rectangulaire du segment réflecteur impose un mode d'oscillation monomode transversalement, avec une direction de polarisation constante, tandis que le segment de phase assure la transition géométrique entre la couche active du milieu amplificateur et le guide du segment réflecteur. Par ailleurs, la présence du segment de phase permet un réglage fin de la longueur d'onde d'oscillation par injection d'un courant électrique approprié.

Selon une première variante de réalisation, le second réflecteur est constitué par une face semi-réfléchissante disposée à la seconde extrémité du segment d'amplification.

Selon un autre aspect de réalisation permettant un meilleur couplage entre le composant et une fibre optique externe, l'extrémité du milieu amplificateur qui se trouve à proximité de la face réfléchissante présente un effilement.

Selon une seconde variante de réalisation, le composant comporte un second segment d'accord muni d'un guide optique couplé à la seconde extrémité du segment amplificateur, ledit second segment d'accord ayant une structure symétrique de celle du premier segment d'accord par rapport au segment de gain.

Cette dernière disposition présente l'avantage que l'on peut réduire les réflexions du signal d'entrée par la face du composant recevant ce signal. De plus, la forme rectangulaire des guides au niveau des faces du composant assure un bon couplage avec des fibres optiques externes.

L'invention a également pour objet un convertisseur de longueur d'onde utilisant le composant selon l'invention ainsi qu'un amplificateur à gain stabilisé utilisant la structure de la seconde variante de réalisation du composant selon l'invention.

D'autres caractéristiques et aspects de réalisation de l'invention apparaîtront dans la suite de la description en référence aux figures.
- les figures 1 et 2 représentent schématiquement un premier mode de réalisation du composant selon l'invention;
- les figures 3 et 4 représentent schématiquement un second mode de réalisation du composant selon l'invention;
- la figure 5 est une vue en perspective du composant avec arrachement montrant les couches de formation en cours de fabrication;
- la figure 6 illustre l'utilisation du composant en tant que convertisseur de longueur d'onde;
- la figure 7 illustre l'utilisation du composant en tant que qu'amplificateur à gain stabilisé.

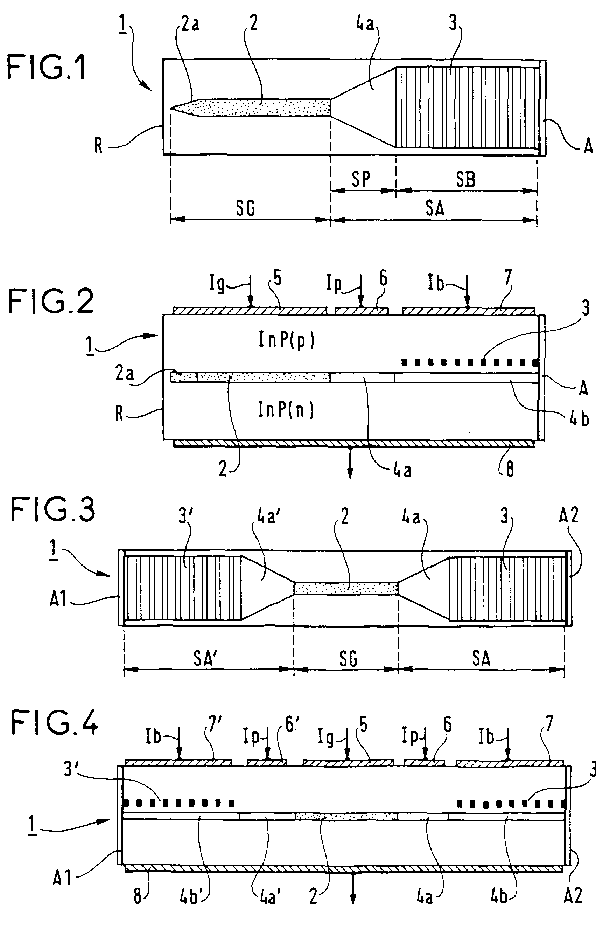

La première variante de réalisation du composant est représentée schématiquement sur les figures 1 et 2, la figure 1 étant une vue de dessus et la figure 2 une coupe longitudinale.

Selon cet exemple, le composant 1 est fabriqué sur un substrat semiconducteur InP dopé n. Sur ce substrat est formée une couche active 2 constituée d'un alliage quaternaire InGaAsP définissant un segment d'amplification SG. La couche active 2 a une section sensiblement carrée et se prolonge par un guide optique dont la largeur est d'abord croissante puis constante. La portion du guide à largeur croissante 4a définit un segment de phase et sa portion à largeur constante 4b se situe au-dessous d'un réseau de Bragg 3 pour définir un segment réflecteur SB. Le réseau de Bragg est formé dans la couche In Ga As P dopée P qui se trouve au-dessus du guide 4b et réalise une variation périodique d'indice à proximité de la section 4b du guide. Le réseau 3 est réalisé par masquage holographique et gravure chimique, suivi d'une reprise d'épitaxie InP dopé p.

L'extrémité externe de la couche active 2 se prolonge par un effilement 2a qui se termine à proximité de la face R du composant. La face R est semi-réfléchissante de façon à former avec le réseau de Bragg une cavité laser résonante. La face opposée A est avantageusement traitée antireflet de façon à limiter les réflexions d'ondes vers la face R.

A la partie supérieure du composant sont placés des électrodes 5, 6, 7 qui recouvrent respectivement les segments SG, SP, SB. Une élecrode commune 8 est placée à la base du composant. L'électrode 5 permet d'injecter le courant d'amplification Ig, tandis que les électrodes 6 et 7 permettent d'injecter des courants Ip, Ib servant au réglage de la longueur d'onde d'oscillation de la cavité.

Les figures 3 et 4 représentent respectivement les vues de dessus et en coupe longitudinale d'une deuxième variante de réalisation. Elle diffère de la précédente simplement par le fait que le rôle de miroir joué par la face R est remplacé par un second segment d'accord SA' couplé à la couche active et de structure symétrique de celle du premier d'accord SA par rapport au segment de gain SG. On prévoit par ailleurs les électrodes supplémentaires correspondantes 6', 7'. Dans cette réalisation, la cavité résonante étant formée par deux réseaux de Bragg opposés, les deux faces externes A1, A2 du composant peuvent être traitées anti-reflet.

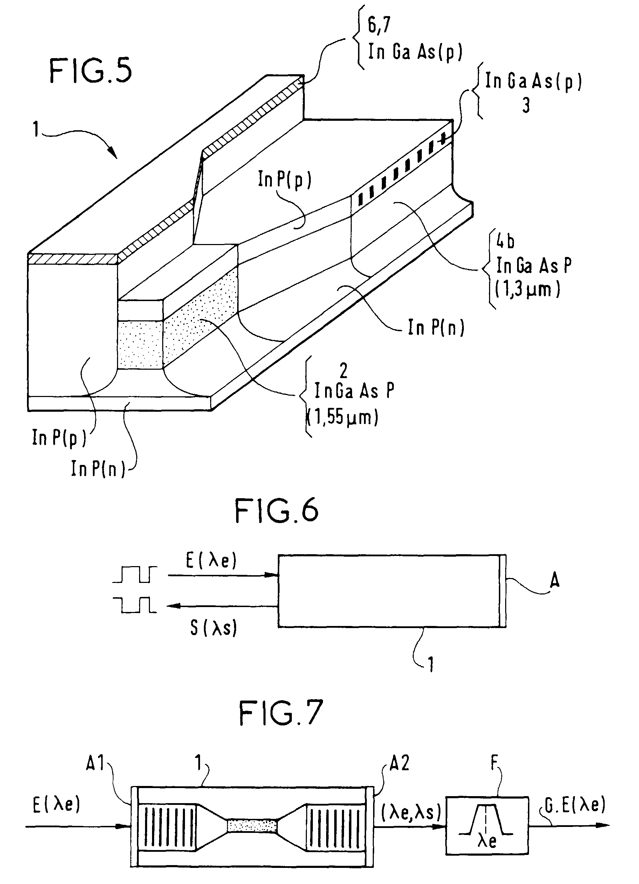

La vue en perspective avec arrachement représentée à la figure 5 permet de visualiser les différentes étapes de fabrication du composant. On y retrouve les mêmes éléments que sur les figures précédentes avec l'indication des compositions des différentes couches.

Pour des raisons de clarté, la représentation du composant par les figures ne montre pas les proportions réelles de ses dimensions. Dans une réalisation concrète, nous aurons par exemple les dimensions suivantes :
- épaisseur du guide 4a, 4b : 0,3 µm
- épaisseur de la couche 2 : 0,4 µm
- largeur de la couche 2 : 0,5 µm
- largeur du guide 4b : 2,5 µm
- longueur du segment réflecteur SB : 400 à 600 µm
- longueur du segment amplificateur SG : 300 à 1000 µm
- longueur du segment de phase SP : 120 µm
- longueur de l'effilement : 70 µm

La figure 6 illustre l'utilisation du composant en tant que convertisseur de longueur d'onde. Dans le cas de la première variante de réalisation, le signal d'entrée E est appliqué sur la face semiréfléchissante R à travers laquelle ressort le signal de sortie S. Le signal E a la forme d'une modulation d'une onde porteuse de longueur d'onde λe. Son niveau haut est supposé suffisant pour assurer la saturation du milieu amplificateur (déplétion des porteurs). Ainsi, lorsque le niveau du signal d'entrée est haut, celui du signal de sortie est bas et réciproquement. Le second mode de réalisation peut être utilisé de façon analogue pour réaliser un convertisseur de longueur d'onde. Toutefois, le composant étant symétrique, le signal d'entrée peut être appliqué à n'importe laquelle de ses faces.

La figure 7 représente l'utilisation du composant selon la seconde variante de réalisation pour réaliser un amplificateur à gain stabilisé. Dans ce cas, le signal d'entrée E est appliqué sur l'une des faces A1. L'onde de sortie traversant la face A2 est appliquée à un filtre F accordé sur la longueur d'onde λe de la porteuse du signal d'entrée.

## Revendications

1. Composant opto-électronique intégré comportant :
- un segment d'amplification (SG) muni d'un milieu amplificateur optique (2) saturable et
- un segment d'accord (SA) muni d'un guide optique (4a, 4b) couplé à une première extrémité dudit milieu amplificateur (2),
lesdits segments amplificateur (SG) et d'accord (SA) étant délimités par un premier et un second réflecteur, ledit premier réflecteur étant réalisé au moyen d'un réseau de Bragg (3) placé dans ledit segment d'accord (SA), ledit composant étant caractérisé en ce que ledit milieu amplificateur (2) est dimensionné de façon à présenter un gain sensiblement indépendant de la polarisation des ondes optiques qu'il reçoit et en ce que ledit guide optique (4a, 4b) du segment d'accord (SA) est dimensionné au niveau du réseau de Bragg (3) de façon à imposer une oscillation optique monomode transversalement, avec une polarisation rectiligne.

2. Composant selon la revendication 1, caractérisé en ce que ledit milieu amplificateur (2) comprend une couche active ayant une section sensiblement carrée et en ce que ledit segment d'accord (SA) est constitué d'un segment réflecteur (SB) couplé au segment amplificateur (SG) par l'intermédiaire d'un segment de phase (SP), ledit segment réflecteur (SB) comportant ledit réseau de Bragg et un guide optique rectangulaire (4b) associé, ledit segment de phase (SP) étant muni d'un guide optique (4a) de largeur variable de façon à assurer la transition entre la largeur de ladite couche active (2) et la largeur du guide optique (4b) du segment réflecteur (SB).

3. Composant selon l'une des revendications 1 ou 2, caractérisé en ce que le second réflecteur est constitué d'une face semi-réfléchissante (R) disposée à la seconde extrémité du segment amplificateur (SG).

4. Composant selon la revendication 3, caractérisé en ce que l'extrémité du milieu amplificateur (2) qui se trouve à proximité de la face semi-réfléchissante (R) présente un effilement (2a).

5. Composant selon l'une des revendications 3 ou 4, caractérisé en ce que la face externe (A) dudit segment d'accord (SA) est traitée antireflet.

6. Composant selon l'une des revendications 1 ou 2, caractérisé en ce qu'il comporte un second segment d'accord (SA') muni d'un guide optique (4a', 4b') couplé à la seconde extrémité du segment amplificateur (SG), ledit second segment d'accord (SA') ayant une structure symétrique de celle du premier segment d'accord (SA) par rapport au segment de gain (SG).

7. Composant selon la revendication 6, caractérisé en ce que les faces externes (A1, A2) desdits segments d'accord (SA, SA') sont traitées antireflet.

8. Convertisseur de longueur d'onde pour fournir une onde optique de sortie modulée (S) en fonction d'une onde optique d'entrée modulée (E), ladite onde optique de sortie (S) ayant une longueur d'onde (λs) différente de celle de l'onde optique d'entrée (E), caractérisé en ce qu'il est constitué d'un composant opto-électronique (1) selon l'une des revendications 1 à 7, ladite longueur d'onde de sortie (λs) étant imposée par ledit réseau de Bragg (3), ledit signal d'entrée (E) étant appliqué sur la face du composant qui est opposée audit segment d'accord (SA).

9. Amplificateur optique à gain stabilisé, caractérisé en ce qu'il comporte un composant selon l'une des revendications 6 ou 7.

## Patentansprüche

1. Integriertes optoelektronisches Bauteil, welches umfaßt:
- ein Verstärkungssegment (SG), das mit einem sättigbaren, optischen Verstärkermedium (2) versehen ist, und
- ein Abstimmsegment (SA), das mit einem Lichtwellenleiter (4a, 4b) versehen ist, der an ein erstes Ende des Verstärkermediums (2) gekoppelt ist,
wobei die Verstärker- (SG) und Abstimmsegmente (SA) von einem ersten und einem zweiten Reflektor begrenzt sind, wobei der erste Reflektor mittels eines Bragg-Gitters (3) ausgeführt ist, das im Abstimmsegment (SA) angeordnet ist, dadurch gekennzeichnet, daß das Verstärkermedium (2) so bemessen ist, daß es eine von der Polarisation der Lichtwellen, die es empfängt, im wesentlichen unabhängige Verstärkung aufweist, und daß der Lichtwellenleiter (4a, 4b) des Abstimmsegments (SA) in Höhe des Bragg-Gitters (3) so bemessen ist, daß eine quer monomodale optische Schwingung mit Linearpolarisation auferlegt wird.

2. Bauteil nach Anspruch 1, dadurch gekennzeichnet, daß das Verstärkermedium (2) eine aktive Schicht mit einem im wesentlichen quadratischen Querschnitt umfaßt und daß das Abstimmsegment (SA) aus einem reflektierenden Segment (SB) besteht, das über ein Phasensegment (SP) an das Verstärkersegment (SG) gekoppelt ist, wobei das reflektierende Segment (SB) das Bragg-Gitter und einen zugehörigen rechteckigen Lichtwellenleiter (4b) aufweist, wobei das Phasensegment (SP) mit einem Lichtwellenleiter (4a) mit variabler Breite versehen ist, um den Übergang zwischen der Breite der aktiven Schicht (2) und der Breite des Lichtwellenleiters (4b) des reflektierenden Segments (SB) sicherzustellen.

3. Bauteil nach einem der Ansprüche 1 oder 2, dadurch gekennzeichnet, daß der zweite Reflektor aus einer halbdurchlässigen Stirnfläche (R) besteht, die am zweiten Ende des Verstärkungssegments (SG) angeordnet ist.

4. Bauteil nach Anspruch 3, dadurch gekennzeichnet, daß das Ende des Verstärkermediums (2), das sich in der Nähe der halbdurchlässigen Stirnfläche (R) befindet, eine Spitze (2a) aufweist.

5. Bauteil nach einem der Ansprüche 3 oder 4, dadurch gekennzeichnet, daß die äußere Stirnfläche (A) des Abstimmsegments (SA) entspiegelt ist.

6. Bauteil nach einem der Ansprüche 1 oder 2, dadurch gekennzeichnet, daß es ein zweites Abstimmsegment (SA') aufweist, das mit einem Lichtwellenleiter (4a', 4b') versehen ist, der an das zweite Ende des Verstärkersegments (SG) gekoppelt ist, wobei das zweite Abstimmsegment (SA') bezüglich des Verstärkungssegments (SG) einen zu demjenigen des ersten Abstimmsegments (SA) symmetrischen Aufbau hat.

7. Bauteil nach Anspruch 6, dadurch gekennzeichnet, daß seine äußeren Stirnflächen (A1, A2) der Abstimmsegmente (SA, SA') entspiegelt sind.

8. Wellenlängenwandler zum Liefern einer modulierten Ausgangslichtwelle (S) in Abhängigkeit von einer modulierten Eingangslichtwelle (E), wobei die Ausgangslichtwelle (S) eine von derjenigen der Eingangslichtwelle (E) verschiedene Wellenlänge (λs) hat, dadurch gekennzeichnet, daß er aus einem optoelektronischen Bauteil (1) nach einem der Ansprüche 1 bis 7 besteht, wobei die Ausgangswellenlänge (λs) durch das Bragg-Gitter (3) auferlegt wird, wobei das Eingangssignal (E) auf die Stirnfläche des Bauteils gegeben wird, die dem Abstimmsegment (SA) gegenüberliegt.

9. Optischer Verstärker mit stabilisierter Verstärkung, dadurch gekennzeichnet, daß er ein Bauteil nach einem der Ansprüche 6 oder 7 umfaßt.

## Claims

1. An integrated opto-electronic component including:
- an amplifying segment (SG) having a saturable optical amplifying medium (2) and
- a tuning segment (SA) having an optical waveguide (4a, 4b) coupled to a first end of said amplifying medium (2),
said amplifying segment (SG) and said tuning segment (SA) being delimited by first and second reflectors, said first reflector being a Bragg grating (3) placed in said tuning segment (SA), said component being characterized in that said amplifying medium (2) is dimensioned to have a gain substantially independent of the polarization of the optical waves that it receives and in that said optical waveguide (4a, 4b) of the tuning segment (SA) is dimensioned at the location of the Bragg grating (3) to impose transversely monomode optical oscillation with rectilinear polarization.

2. A component as claimed in claim 1 characterized in that said amplifying medium (2) comprises an active layer having a substantially square cross-section and in that said tuning segment (SA) comprises a reflecting segment (SB) coupled to the amplifying segment (SG) by a phase segment (SP), said reflecting segment (SB) including said Bragg grating and an associated rectangular optical waveguide (4b), said phase segment (SP) having an optical waveguide (4a) of varying width to provide the transition between the width of said active layer (2) and the width of the optical waveguide (4b) of the reflecting segment (SB).

3. A component as claimed in claim 1 or 2 characterized in that the second reflector comprises a semireflecting face (R) at the second end of the amplifying segment (SG).

4. A component as claimed in claim 3 charcterized in that the end of the amplifying medium (2) near the semireflecting face (R) is tapered (2a).

5. A component as claimed in either claim 3 or claim 4 characterized in that the external face (A) of said tuning segment (SA) is antireflection treated.

6. A component as claimed in either claim 1 or claim 2 characterized in that it includes a second tuning segment (SA') having an optical waveguide (4a', 4b') coupled to the second end of the amplifying segment (SG), said second tuning segment (SA') having a structure symmetrical to that of the first tuning segment (SA) about the gain segment (SG).

7. A component as claimed in claim 6 characterized in that the external faces (A1, A2) of said tuning segments (SA, SA') are antireflection treated.

8. A wavelength converter adapted to supply an output optical wave (S) modulated in accordance with a modulated input optical wave (E), said output optical wave (S) having a wavelength (λs) different than that of the input optical wave (E), characterized in that it comprises an opto-electronic component (1) as claimed in any of claims 1 to 7, said output wavelength (λs) being imposed by said Bragg grating (3), said input signal (E) being applied to the face of the component opposite said tuning segment (SA).

9. Stabilized gain optical amplifier characterized in that it comprises a component as claimed in either claim 6 or claim 7.
